# EUROPEAN PATENT APPLICATION

(11) **EP 4 567 864 A1**
(43) Date of publication of application: **11.06.2025**
(21) Application number: 24209180.9
(22) Date of filing: 28.10.2024
(51) Int. Cl.: H01L 21/48, H01L 23/498, H01L 23/538, H01L 23/15

(54) **EMBEDDED BRIDGE WITH THROUGH SILICON VIA BONDING ARCHITECTURES**

(30) Priority: 06.12.2023 US 202318530768
(71) Applicant: INTEL Corporation, Santa Clara, CA 95054 (US)
(72) Inventor: MARIN, Brandon, Gilbert, 85234 (US); LIU, Minglu, Chandler, 85248 (US); SHAN, Bohan, Chandler, 85226 (US); ANGOUA, Bainye Francoise, Phoenix, 85045 (US); PIETAMBARAM, Srinivas Venkata Ramanuja, Chandler, 85249 (US); DUAN, Gang, Chandler, 85248 (US); AHMED, Numair, Chandler, 85286 (US); ECTON, Jeremy D., Gilbert, 85298 (US); DUONG, Benjamin, Phoenix, 85044 (US); FENG, Hongxia, Chandler, 85239 (US); NIE, Bai, Chandler, 85249 (US); CHEN, Haobo, Chandler, 85249 (US); LIN, Ziyin, Chandler, 85248 (US); BAI, Yiqun, Chandler, 85249 (US); ARRINGTON, Kyle, Gilbert, 85297 (US); WAIMIN, Jose, Gilbert, 85295 (US); CARRAZZONE, Ryan, Chandler, 85226 (US); XU, Dingying David, Chandler, 85248 (US); MU, Bin, Tempe, 85284 (US); GUPTA, Mohit, Chandler, 85249 (US); GUO, Xiaoying, Chandler, 85248 (US); GUNAWAN, Andrey, Scottsdale, 85258 (US); ZHANG, Yingying, Phoenix, 85048 (US); KANAOKA, Yosuke, Chandler, 85249 (US); KORNBLUTH, Yosef, Phoenix, 85014 (US); CANDADAI, Aaditya Anand, Chandler, 85226 (US); ROSALES-YEOMANS, Daniel, Gilbert, 85297 (US); KONG, Jieying, Chandler, 85286 (US); LAI, Shugi, Phoenix, 85045 (US); WANG, Ao, Chandler, 85224 (US); STACEY, Joshua, Chandler, 85286 (US); SENEVIRATNE, Dilan, Phoenix, 85048 (US); LEWIS, Jade Sharee, Phoenix, 85042 (US)
(74) Representative: Goddar, Heinz J.

(57) **Abstract**

Embodiments disclosed herein include bridge structures for package substrates. In an embodiment, a package substrate comprises a substrate that is a dielectric material. In an embodiment, a cavity is formed into the substrate. A first pad is on a bottom surface of the cavity, and a die is at least partially in the cavity. In an embodiment, a via passes through at least a portion of a thickness of the die, and a second pad is on the die. In an embodiment, the second pad directly contacts the first pad, and the first pad is the only electrically conductive structure between the via and the second pad.

## Description

### BACKGROUND

Computing architectures continue to scale to smaller form factors while pushing towards higher bandwidths and computing capacity. One solution for enabling such design goals is to use chiplet architectures. Instead of a single large chip, a plurality of smaller chiplets are stitched together by a bridge. When the bridge is embedded in the underlying package substrate, the bridge may be referred to as an embedded bridge solution. Existing bridge solutions typically do not allow for power to pass through a thickness of the bridge. Instead, traces are routed over the bridge in order to provide power within the footprint of the bridge. This complicates routing and increases the length of the power delivery path, which can impact performance.

Accordingly, some solutions have proposed using vias through a thickness of the bridge. This allows for power to pass directly through the bridge and reduces path length and mitigates routing complexity. However, the integration of such bridges into the package substrate is not without issue. One issue that arises with such architectures is that the current capacity passing through the bridge is limited by traditional solder interconnect solutions. Additionally, the solder increases the standoff height of the bridge. This increases the depth of the cavity in the package substrate that is used to accommodate the bridge. Another issue that may arise is the underfill uniformity. Particularly, tight pitches and small gaps makes it difficult to dispense underfill material between the bridge and the bottom of the cavity. This leads to voids which can pose reliability issues for the package substrate.

### BRIEF DESCRIPTION OF THE DRAWINGS

Figure 1A is a cross-sectional illustration of a package substrate with an embedded bridge that includes power routed around the perimeter of the bridge, in accordance with an embodiment.
Figure 1B is a cross-sectional illustration of a package substrate with an embedded bridge that includes through silicon vias, in accordance with an embodiment.
Figures 2A - 2C are cross-sectional illustrations depicting a process for inserting a bridge in a cavity using a porous bump architecture, in accordance with an embodiment.
Figures 3A and 3B are cross-sectional illustrations depicting the interconnect with a porous bump and a regular solder bump, in accordance with various embodiments.
Figures 4A - 4H are cross-sectional illustrations depicting a process for hybrid bonding a bridge to the bottom of a cavity, in accordance with an embodiment.
Figure 5A is a cross-sectional illustration of a package substrate with a hybrid bonded bridge, in accordance with an embodiment.
Figure 5B is a cross-sectional illustration of the hybrid bonded interface with gold or silver liners, in accordance with an embodiment.
Figure 6 is a cross-sectional illustration of a package substrate with a bridge that includes a hybrid bonded interface, in accordance with an embodiment.
Figures 7A - 7C are cross-sectional illustrations of a process for hybrid bonding a bridge to a package substrate with compressible dielectric layers, in accordance with an embodiment.
Figure 7D is a cross-sectional illustration of a portion of the compressible dielectric layer with filler spheres, in accordance with an embodiment.
Figures 8A - 8C are cross-sectional illustrations depicting a process for hybrid bonding a bridge to a package substrate with a dielectric layer that includes vapor infiltration particles, in accordance with an embodiment.
Figures 9A - 9E are cross-sectional illustrations depicting a process for hybrid bonding a bridge to a package substrate with a B-stage dielectric layer, in accordance with an embodiment.
Figure 10 is a cross-sectional illustration of an electronic system with a package substrate that includes an embedded bridge that is hybrid bonded to the package substrate, in accordance with an embodiment.
Figure 11 is a schematic of a computing device built in accordance with an embodiment.

### EMBODIMENTS OF THE PRESENT DISCLOSURE

Described herein are electronic systems, and more particularly, architectures for coupling an embedded bridge with vias to an underlying package substrate, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment.

As noted above, embedded bridge architectures have been used in order to implement device scaling which can lead to smaller devices while maintaining or improving device performance. However, continued scaling of embedded bridge structures has led to greater issues with electrically coupling the bridge to other features within the package substrate.

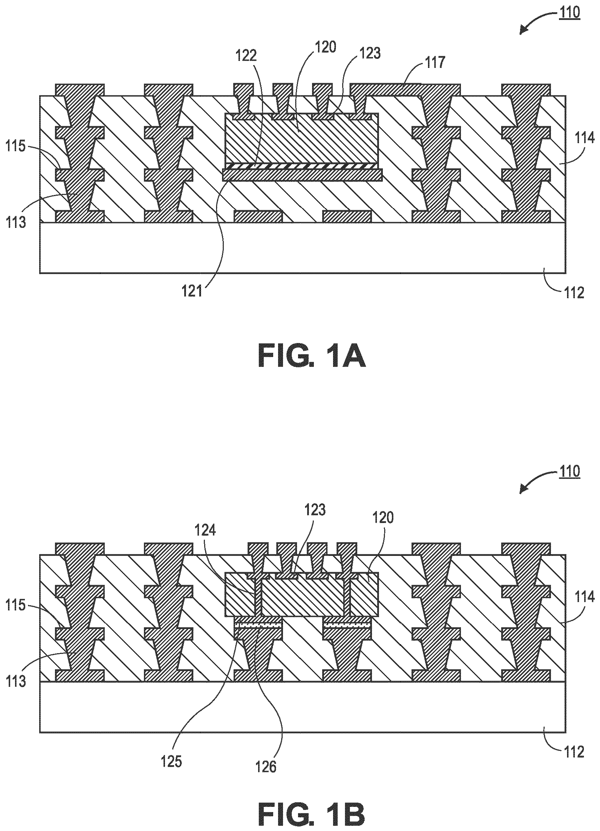

An example of a typical embedded bridge structure is shown in Figure 1A. In Figure 1A, a cross-sectional illustration of a package substrate 110 is shown, in accordance with an embodiment. In an embodiment, the package substrate 110 comprises a core 112. The core 112 may be any suitable core material. For example, the core 112 may comprise an organic core with glass fiber reinforcement or the core 112 may comprise a substantially solid glass layer. While shown as a monolithic structure, the core 112 typically includes electrically conductive vias that pass through a thickness of the core 112. In an embodiment, buildup layers 114 may be provided over the core 112. Buildup layers 114 may also be provided over the bottom of the core 112. The bottom portion of the package substrate 110 is omitted from Figure 1A for clarity since the bridge 120 is located in the top portion of the package substrate 110. The buildup layers 114 may comprise an organic dielectric material. For example, multiple dielectric layers may be laminated over each other in order to form the larger structure of the buildup layers 114. In an embodiment, the buildup layers 114 may comprise electrically conductive routing, such as vias 113, pads 115, traces 117, and the like. The electrically conductive routing may comprise copper, copper alloys, or other metallic materials.

In an embodiment, the bridge 120 is embedded within the buildup layers 114. The bridge 120 may also be referred to as a "die" or a "bridge die" in some embodiments. The bridge 120 may be a dimensionally stable material. For example, the bridge 120 may comprise silicon, other semiconductor materials, a ceramic, glass, or the like. In an embodiment, electrically conductive routing (e.g., traces, pads, etc.) may be provided on the bridge 120. For example, pads 123 are shown in Figure 1A. In some instances, the routing may be provided in back-end-of-line (BEOL) layers (not shown) over the dimensionally stable base material (e.g., silicon). The BEOL layers may include dielectric materials, such as silicon oxide, silicon nitride, organic dielectrics, and the like. The dimensional stability of the bridge 120 allows for fine line and space (L/S) dimensions in order to provide electrical coupling between overlying dies (not shown in Figure 1A). In an embodiment, the bridge 120 may be provided over an etchstop layer 121. The etchstop layer 121 may comprise copper or the like. The bridge 120 may be secured to the etchstop layer 121 by an adhesive 122 or the like.

In the illustrated embodiment, there are no vias through a thickness of the bridge 120. Accordingly, power is not able to be routed through the bridge 120. Instead, power is provided in a path that passes adjacent to a sidewall of the bridge 120. Once above the level of the top surface of the bridge 120, a trace 117 can route power into the footprint of the bridge 120. This increases the length of the power delivery path and decreases performance. Additionally, the lateral routing makes routing within the package substrate 110 more complicated.

Accordingly, embodiments disclosed herein may utilize a bridge 120 that includes vias 124. An example of such an embodiment is shown in Figure 1B. As shown, the vias 124 pass through at least a portion of the thickness of the bridge 120. Pads 125 at the bottom of the bridge 120 are coupled to pads 123 at the top of the bridge 120 through the vias 124. In an embodiment, the bottom pads 125 are coupled to pads 115 in the buildup layers 114 through a solder 126 or the like. In order to make the necessary electrical connections, the thickness variation of the buildup layers 114 needs to be low.

When a glass core 112 is used, thickness variation is typically improved. The improvement is maximized as the bridge 120 is moved closer to the surface of the glass core 112. That is, reducing the thickness of the buildup layers 114 between the bridge 120 and the core 112 is beneficial. However, as the bridge 120 is moved closer to the core 112, potential for damaging the core 112 is increased. The core 112 is brittle and is prone to cracking or other damage. Accordingly, some amount of buffer layer is currently necessary between the core 112 and the bottom of the bridge 120.

However, the solder 126 between the bridge 120 and the pad 115 on the buildup layers 114 may result in several issues. For example, the solder 126 has poor current carrying capability, which leads to a less than desirable IMAX value. Additionally, underfill may be needed around the solder 126. Due to tight pitch between interconnects, voids may be formed. Voids negatively impact product reliability. Solder 126 also increases the standoff height of the device, and the cavity to accommodate the bridge 120 needs to be deeper.

Therefore, embodiments disclosed herein provide improved interconnect architectures in order to address these issues. In one embodiment, a hybrid bonding architecture is used to couple the bridge to the bottom surface of the cavity in the buildup layers. A hybrid bonding architecture may use direct copper-to-copper bonding and dielectric-to-dielectric (or silicon-to-dielectric) bonding around the pads. In an embodiment, the hybrid bonding may incorporate dielectric material modification. For example, silica spheres may be embedded in the dielectric layer to enable improved compressibility. A vapor infiltration process may also be used to integrate inorganic particles into the dielectric layer in order to modify coefficient of thermal expansion (CTE). A B-stage dielectric may also be used in some embodiments. In an additional embodiment, the pads of the hybrid bonding architecture may include gold and/or silver (either as the entire pad or as a liner over the pad).

In other instances, a porous bump architecture may be used instead of hybrid bonding. The porous bump architecture may include metals that have a higher electrical conductivity than solder. Also, the porous bump architecture may allow for a greater degree of freedom for placement of the bridge in the cavity. As such, assembly processes are simplified.

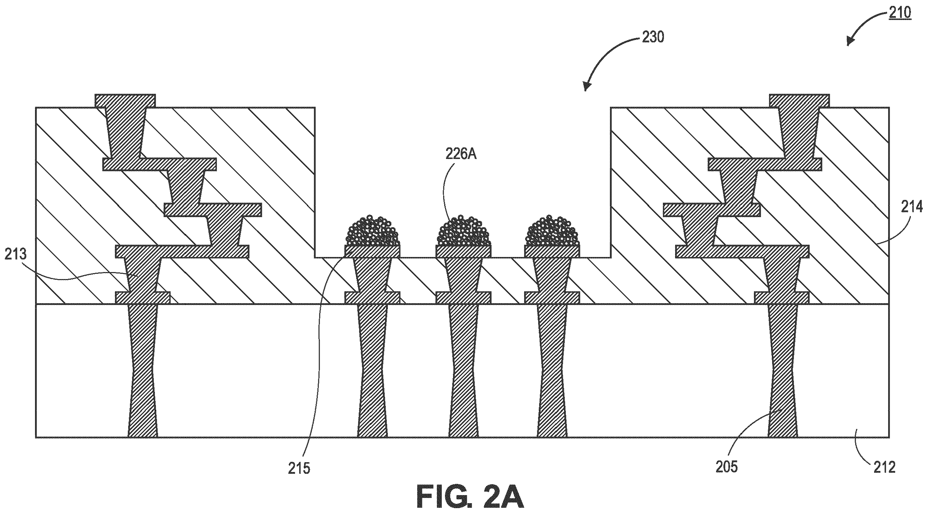

Referring now to Figures 2A - 2C, a series of cross-sectional illustrations depicting a process for assembling a package substrate 210 with an embedded bridge 220 is shown, in accordance with an embodiment. In the particular embodiment shown in these Figures, the bridge 220 includes vias 224 (e.g., through silicon vias (TSVs) or the like). As such, an electrical connection between the bottom of the bridge 220 and the bottom surface of the cavity 230 is needed. This interconnect may comprise a two-part solution. A first portion may include a porous metal bump, and a second portion may include a solder or the like.

Referring now to Figure 2A, a cross-sectional illustration of the package substrate 210 at a stage of manufacture is shown, in accordance with an embodiment. In an embodiment, the package substrate 210 may comprise a core 212 with buildup layers 214 over the core 212. In Figures 2A - 2C only the top side of the package substrate 210 is shown for simplicity. It is to be appreciated that buildup layers 214 with associated electrical routing may also be provided below the core 212. In an embodiment, the buildup layers 214 may be organic dielectric layers. For example, buildup film layers may be laminated over each other in order to form the buildup layers 214. Electrically conductive features, such as vias 213, pads 215, traces, etc. may be embedded in the buildup layers 214. The core 212 may be an organic core, a glass core, or any other suitable core material.

The core 212 may be substantially all glass. The core 212 may be a solid mass comprising a glass material with an amorphous crystal structure where the solid glass core may also include various structures - such as vias, cavities, channels, or other features - that are filled with one or more other materials (e.g., metals, metal alloys, dielectric materials, etc.). As such, core 212 may be distinguished from, for example, the "prepreg" or "RF4" core of a Printed Circuit Board (PCB) substrate which typically comprises glass fibers embedded in a resinous organic material, such as an epoxy.

The core 212 may have any suitable dimensions. In a particular embodiment, the core 212 may have a thickness that is approximately 50µm or greater. For example, the thickness of the core 212 may be between approximately 50µm and approximately 1.4mm. Though, smaller or larger thicknesses may also be used. The core 212 may have edge dimensions (e.g., length, width, etc.) that are approximately 10mm or greater. For example, edge dimensions may be between approximately 10mm to approximately 250mm. Though, larger or smaller edge dimensions may also be used. More generally, the area dimensions of the core 212 (from an overhead plan view) may be between approximately 10mm × 10mm and approximately 250mm × 250mm. In an embodiment, the core 212 may have a first side that is perpendicular or orthogonal to a second side. In a more general embodiment, the core 212 may comprise a rectangular prism volume with sections (e.g., vias) removed and filled with other materials (e.g., metal, etc.).

The core 212 may comprise a single monolithic layer of glass. In other embodiments, the core 212 may comprise two or more discrete layers of glass that are stacked over each other. The discrete layers of glass may be provided in direct contact with each other, or the discrete layers of glass may be mechanically coupled to each other by an adhesive or the like. The discrete layers of glass in the core 212 may each have a thickness less than approximately 50µm. For example, discrete layers of glass in the core 212 may have thicknesses between approximately 25µm and approximately 50µm. Though, discrete layers of glass may have larger or smaller thicknesses in some embodiments. As used herein, "approximately" may refer to a range of values within ten percent of the stated value. For example approximately 50µm may refer to a range between 45µm and 55µm.

The core 212 may be any suitable glass formulation that has the necessary mechanical robustness and compatibility with semiconductor packaging manufacturing and assembly processes. For example, the core 212 may comprise aluminosilicate glass, borosilicate glass, alumino-borosilicate glass, silica, fused silica, or the like. In some embodiments, the core 212 may include one or more additives, such as, but not limited to, Al₂O₃, B₂O₃, MgO, CaO, SrO, BaO, SnO₂, Na₂O, K₂O, SrO, P₂O₃, ZrO₂, Li₂O, Ti, or Zn. More generally, the core 212 may comprise silicon and oxygen, as well as any one or more of aluminum, boron, magnesium, calcium, barium, tin, sodium, potassium, strontium, phosphorus, zirconium, lithium, titanium, or zinc. In an embodiment, the core 212 may comprise at least 23 percent silicon (by weight) and at least 26 percent oxygen (by weight). In some embodiments, the core 212 may further comprise at least 5 percent aluminum (by weight).

In an embodiment, vias 205 may pass through a thickness of the core 212. The vias 205 may comprise vertical sidewalls, tapered sidewalls, or any other suitable cross-sectional shape. In the particular embodiment shown in Figure 2A, the vias 205 have an hourglass shaped cross-section typical of laser assisted patterning processes. While the buildup layers 214 are directly over the core 212, a buffer layer (not shown) may also be provided between the buildup layers 214 and the core 212 in some embodiments.

In an embodiment, the package substrate 210 may comprise a cavity 230 that is formed into the buildup layers 214. The cavity 230 may be formed with an etching process, a laser ablation process, or the like. In the illustrated embodiment, the cavity 230 has vertical sidewalls. In other instances, the cavity 230 may have sloped sidewalls. The cavity 230 may pass partially through a thickness of the buildup layers 214. That is, a portion of the buildup layers 214 remains between the bottom surface of the cavity 230 and the top surface of the core 212. In other embodiments, the cavity 230 may pass entirely through a thickness of the buildup layers 214.

Pads 215 may be exposed at a bottom of the cavity 230. The pads 215 may extend up from the bottom surface of the cavity 230, as shown in Figure 2A. However, the pads 215 may also be flush with the bottom surface of the cavity 230. That is, the top surface of the pads 215 may be substantially coplanar with the bottom surface of the cavity 230.

In an embodiment, first portions 226A of an interconnect may be provided on the pads 215 in the cavity 230. The first portions 226A may include an electrically conductive material with a first composition and a first structure. For example, the first composition may include one or more electrically conductive metals, such as, but not limited to, tin, copper, nickel, silver, or gold. The first structure may include a porous structure. As used herein, a porous structure refers to a material that has a matrix material (e.g., a metal) and pores (or voids) distributed through the matrix material. The pores or voids may be filled with air or another gas/fluid. In an embodiment, the porous structure may have a porosity that is up to approximately 50% porosity. That is, when viewing a cross-section of the porous first portions 226A, an area of the voids may account for up to approximately 50% of the total area of the first portions 226A.

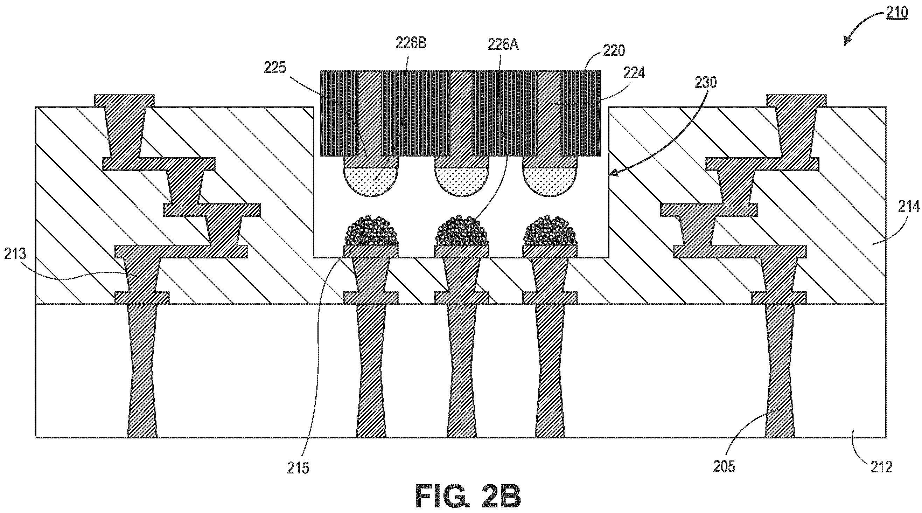

Referring now to Figure 2B, a cross-sectional illustration of the package substrate 210 at another stage of manufacture is shown, in accordance with an embodiment. As shown, a bridge 220 is inserted into the cavity 230. The cavity 230 may have a width that is larger than the width of the bridge 220. In an embodiment, the bridge 220 may comprise a semiconductor substrate, such as silicon. TSVs 224 may pass through at least a portion of the bridge 220. The top of the bridge 220 may include routing, pads, and the like (not shown) for subsequent coupling to overlying dies.

In an embodiment, pads 225 may be provided at the bottom of the bridge 220. The pads 225 may extend out from the bottom surface of the bridge 220. In other instances, the pads 225 may be flush with the bottom surface of the bridge 220. That is, bottom surfaces of the pads 225 may be substantially coplanar with the bottom surface of the bridge 220. In an embodiment, a second portion 226B of the interconnect may be provided on the pads 225.

The second portion 226B of the interconnect may have a second material composition and a second structure. The second material composition may be different than the first material composition of the first portion 226A. For example, the second material composition may include a solder (e.g., a tin-based solder) or the like. Additionally, the second structure may be different than the first structure. For example, the second structure may be substantially non-porous in some embodiments. Other embodiments may include a second portion 226B with a porosity up to approximately 30%.

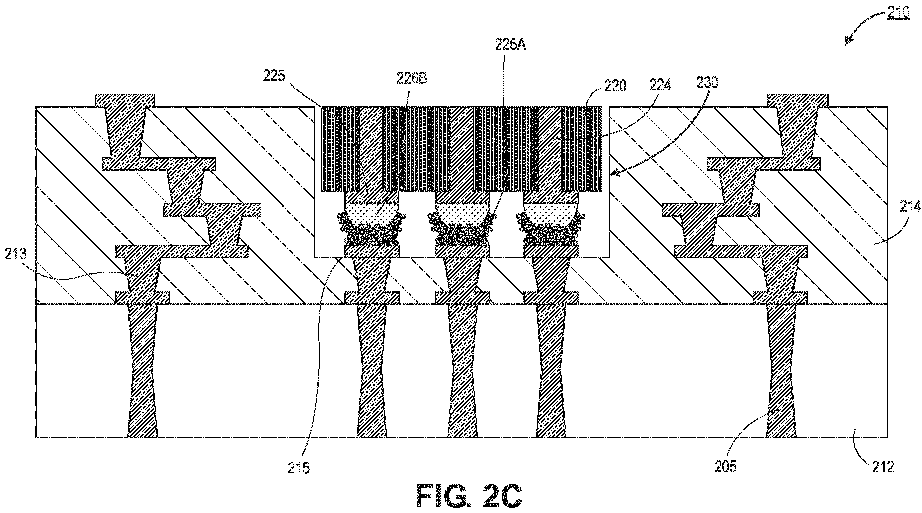

Referring now to Figure 2C, a cross-sectional illustration of the package substrate 210 at a different stage of manufacture is shown, in accordance with an embodiment. As shown, the first portions 226A of the interconnect interface and contact the second portions 226B of the interconnect. As such, an electrical coupling or connection is provided between the bottom of the bridge 220 and the pads 215 on the buildup layers 214. The two portion structure of the interconnects (i.e., first portions 226A and second portions 226B) allow for greater degrees of freedom in the placement accuracy of the bridge 220. As such, assembly is easier, faster, and less expensive compared to existing solder only solutions.

In an embodiment, the remainder of the cavity 230 is unfilled. In other embodiments, an underfill or the like may be provided between the interconnects and/or around the bridge 220 in the cavity 230. The top of the bridge 220 may be substantially coplanar with the top of the buildup layers 214. Though, the top of the bridge 220 may be above the buildup layers 214, or the top of the bridge 220 may be below the top of the buildup layers 214.

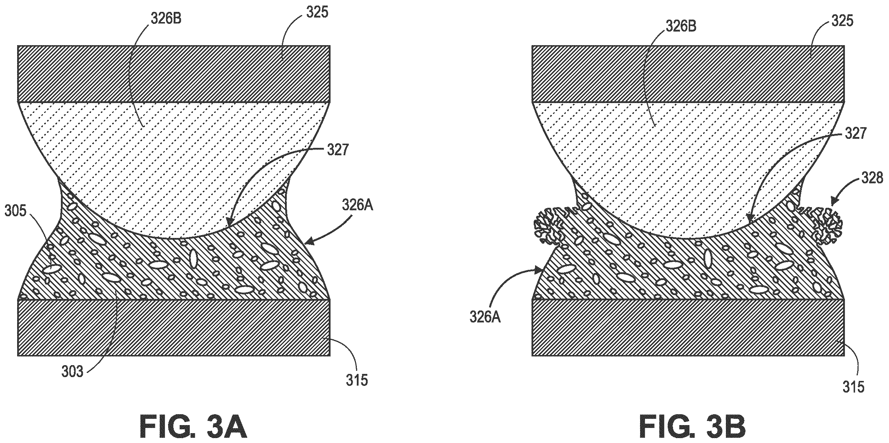

Referring now to Figures 3A and 3B, zoomed in illustrations of the interconnects between the bridge 220 and the bottom of the cavity 230 are shown, in accordance with various embodiments.

Referring now to Figure 3A, a two portion interconnect between a pad 315 and a pad 325 is shown, in accordance with an embodiment. The pad 315 may be at the bottom of a cavity (not shown), and the pad 325 may be provided at the bottom of the bridge (not shown). The interconnect may include a first portion 326A and a second portion 326B. The first portion 326A may have a first composition and a first structure, and the second portion 326B may have a second composition and a second structure.

The first composition may be different than the second composition. The first composition of the first portion 326A may comprise one or more metals, such as, but not limited to, tin, copper, nickel, silver, or gold. The second composition of the second portion 326B may be a standard solder based material, such as a tin-based solder or the like. In an embodiment, the second structure is different than the first structure. For example, a porosity of the first structure is higher than a porosity of the second structure. In an embodiment, the porosity of the first portion 326A may be up to approximately 50% in some embodiments. As shown, the first portion 326A may include a metal matrix 303 with a plurality of voids 305 distributed through the matrix 303. The voids 305 may be air filled, or filled with any gas/fluid material.

As shown in Figure 3A, the first portion 326A may have an interface 327 with the second portion 326B. That is, there may not be significant mixing between the first portion 326A and the second portion 326B. Though, there may be a diffusion region (not shown) proximate to the interface 327 that includes elemental constituents of both the first portion 326A and the second portion 326B. In an embodiment, the interface 327 may be a non-linear line. For example, the interface 327 may be substantially curved with the first portion 326A cupping around the second portion 326B.

Referring now to Figure 3B, a cross-sectional illustration of the interconnect is shown, in accordance with an embodiment. The interconnect in Figure 3B may be substantially similar to the interconnect in Figure 3A, with the exception of the cross-sectional shape of the first portion 326A. In addition to a cupped interface 327 with the second portion 326B, the first portion 326A may include lateral protrusions 328. The lateral protrusions 328 may be the result of the second portion 326B pressing down into the first portion 326A. The lateral protrusions 328 may be peninsula like structures that extend out from an edge of the first portion 326A when viewed in a cross-section, as shown in Figure 3B.

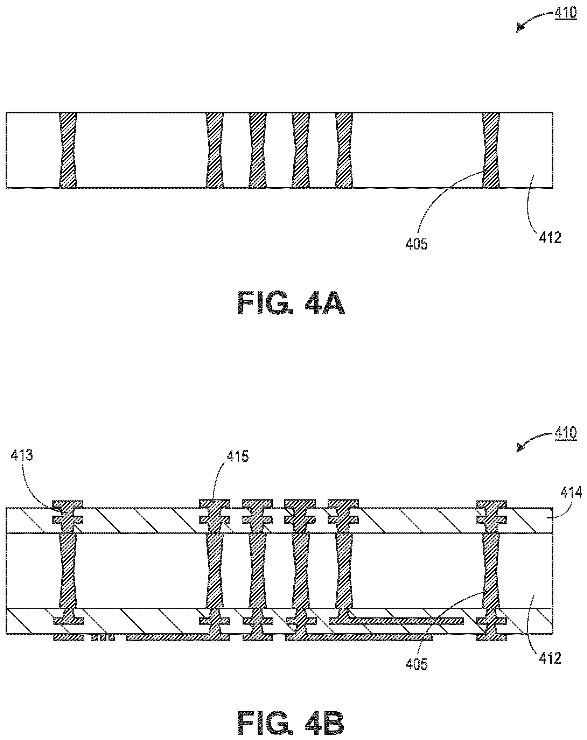

Referring now to Figures 4A - 4H, a series of cross-sectional illustrations depicting a process for forming a package substrate 410 with an embedded bridge that is attached with a hybrid bonding architecture is shown, in accordance with an embodiment.

Referring now to Figure 4A, a cross-sectional illustration of a package substrate 410 at a stage of manufacture is shown, in accordance with an embodiment. The package substrate 410 may comprise a core 412. The core 412 may be a glass core or an organic core similar to any of the cores described in greater detail herein. In an embodiment, vias 405 may pass through a thickness of the core 412. The vias 405 have hourglass shaped cross-sections. Though, the vias 405 may have any suitable cross-sectional shape.

Referring now to Figure 4B, a cross-sectional illustration of the package substrate 410 at an additional stage of manufacture is shown, in accordance with an embodiment. The package substrate 410 has had buildup layers 414 added above and below the core 412. The buildup layers 414 may include electrically conductive routing features, such as vias 413, pads 415, traces, and the like.

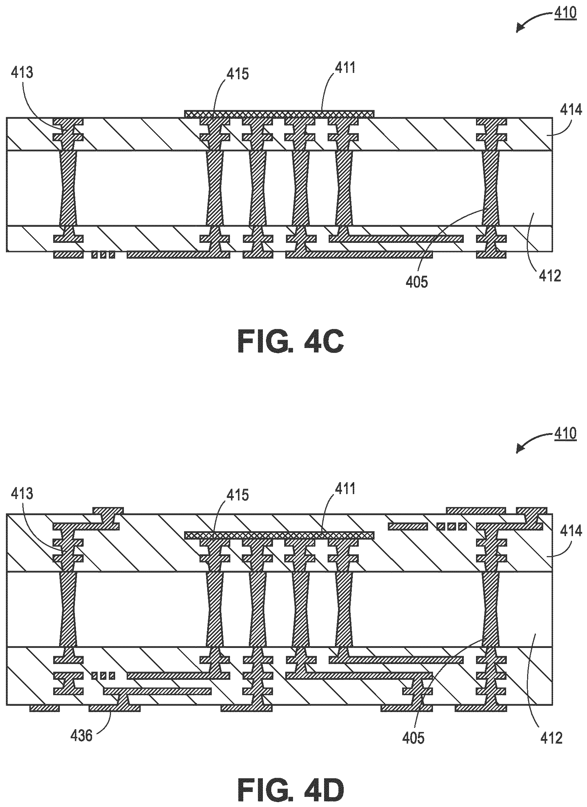

Referring now to Figure 4C, a cross-sectional illustration of the package substrate 410 at a subsequent stage of manufacture is shown, in accordance with an embodiment. The package substrate 410 may include a layer 411 that is provided over some of the pads 415. In an embodiment, an etchstop layer (not shown) may be provided between the layer 411 and the pads 415. For example, an etchstop layer that is etch selective to the material of the layer 411 and the pads 415 may be used. In the case of a copper layer 411 and copper pads 415, the etchstop layer may comprise titanium. The layer 411 may function as a mechanical stop for use in a cavity formation process, as will be described in greater detail below.

Referring now to Figure 4D, a cross-sectional illustration of the package substrate 410 after additional buildup layers 414 are deposited is shown, in accordance with an embodiment. As shown, the buildup layers are applied over the layer 411. The region above the layer 411 is without any electrical routing since the material of the buildup layers 414 in this region will ultimately be removed in the cavity formation process.

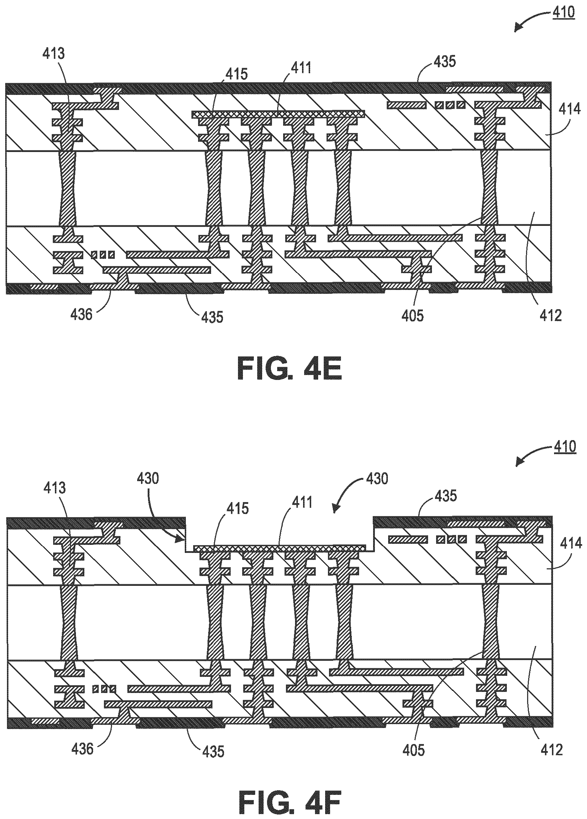

Referring now to Figure 4E, a cross-sectional illustration of the package substrate 410 after solder resist layers 435 are formed is shown, in accordance with an embodiment. The solder resist layers 435 may be formed on the top and bottom surfaces of the package substrate 410. The bottom solder resist layer 435 may be patterned to form openings to expose pads 436. The pads 436 may be where second level interconnects (SLIs) are coupled in order to make a connection with a board (not shown).

Referring now to Figure 4F, a cross-sectional illustration of the package substrate 410 after the cavity 430 is formed is shown, in accordance with an embodiment. In an embodiment, the cavity 430 may extend through the solder resist 435 and into the buildup layers 414. The cavity 430 may stop at the layer 411. In an embodiment, the cavity 430 may be formed with a laser ablation process, an etching process, or any other suitable subtractive process. In the illustrated embodiment, the sidewalls of the cavity 430 are vertical. In other embodiments, sidewalls of the cavity 430 may be tapered. A width of the cavity 430 may be greater than a width of the layer 411. In other embodiments, the width of the cavity 430 may be smaller than a width of the layer 411.

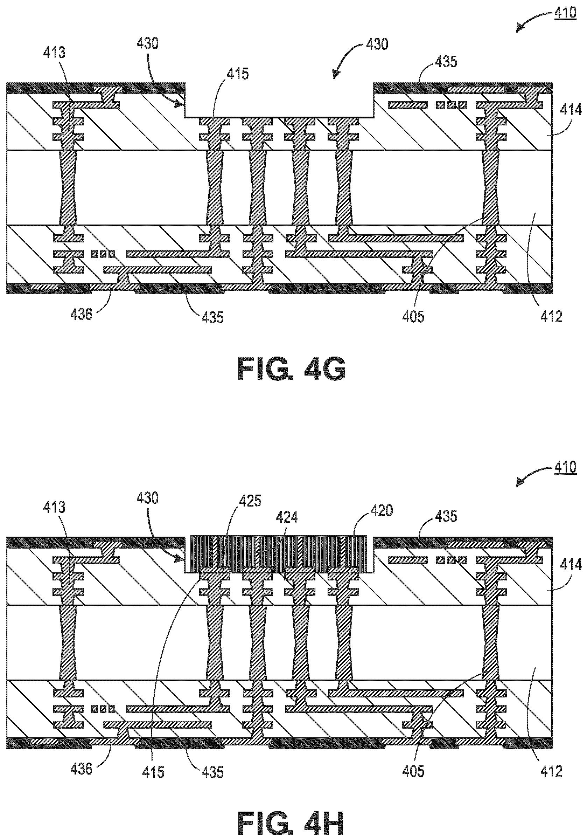

Referring now to Figure 4G, a cross-sectional illustration of the package substrate 410 after the layer 411 is removed is shown, in accordance with an embodiment. In an embodiment, the layer 411 may be removed by an etching process or any other suitable subtractive process. In an embodiment, an etchstop layer (not shown) between the layer 411 and the pads 415 may also be removed with an etching process. As shown, the pads 415 are provided at a bottom surface of the cavity 430. The top surface of the pads 415 may be substantially coplanar with the bottom surface of the cavity 430.

Referring now to Figure 4H, a cross-sectional illustration of the package substrate 410 after the bridge 420 is inserted into the cavity 430 is shown, in accordance with an embodiment. The bridge 420 may comprise vias 424 (e.g., TSVs) with pads 425 at the bottom of the vias 424. The bridge 420 may be a silicon substrate or any other suitable material that enables high density electrical routing.

The pads 425 may be in direct contact with the pads 415. That is, there may not be any solder or the like between the pads 415 and pads 425. Similarly, the bottom surface of the bridge 420 may be in direct contact with the buildup layers 414 at the bottom surface of the cavity 430. That is, a hybrid bonding architecture may be provided that includes copper-to-copper bonds (i.e., pads 415 to pads 425) and dielectric-to-bridge bonds (i.e., buildup layers 414 to bridge 420). The material of the bridge 420 that contacts the bottom surface of the cavity 430 may be silicon or an intervening dielectric layer (not shown). In some embodiments, a treatment of the bottom surface of the cavity 430 and/or the pads 415 may occur before attaching the bridge 420. For example, a plasma treatment process may be used in some embodiments.

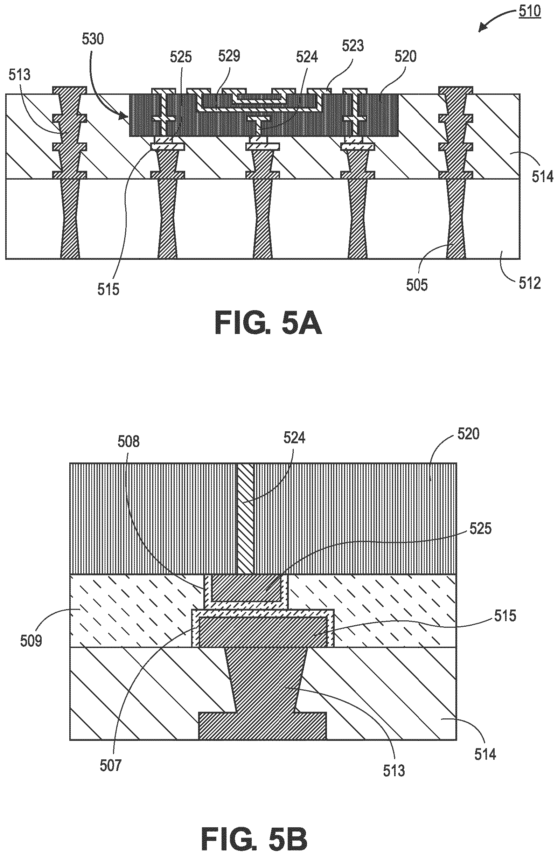

Referring now to Figure 5A, a cross-sectional illustration of a package substrate 510 is shown, in accordance with an additional embodiment. In some instances, the package substrate 510 in Figure 5A allows for improved IMAX capability for several reasons. For one, the solder is removed from between the bottom of the bridge 520 and the buildup layers 514. Additionally, the pads comprise high current carrying materials, such as gold and/or silver.

In an embodiment, the package substrate 510 comprises a core 512 and buildup layers 514 over the core 512. In an embodiment, the core 512 is a glass core or an organic core. A glass core 512 may be similar to any of the core architectures described in greater detail herein. Vias 505 may pass through a thickness of the core 512. The vias 505 may have any suitable cross-sectional shape, such as those described in greater detail herein. Electrically conductive routing (e.g., vias 513, pads 515, and traces) may be provided on and/or in the buildup layers 514.

In an embodiment, a bridge 520 may be at least partially embedded in the buildup layers 514 over the core 512. The bridge 520 may comprise vias 524 (e.g., TSVs). Electrically conductive routing, such as traces 529 and the like, may couple pads 523 together on the top of the bridge 520. In this way, overlying dies (not shown) can be communicatively coupled to each other through the bridge 520.

In an embodiment, the bridge 520 may be coupled to the buildup layers 514 through a bump-to-bump, a bump-to-pad, or a pad-to-pad interface (which may sometimes be referred to as a hybrid bonding interface or architecture). The bump 525 on the bridge 520 side may directly contact a pad 515 on the buildup layers 514. As shown, the shading of bumps 525 and pads 515 are different than the remainder of the electrical routing in the buildup layers 514 in order to indicate a different material is used. For example, the bumps 525 and the pads 515 may comprise one or more high current carrying capacity materials, such as, but not limited to, gold or silver.

In an embodiment, the bumps 525 are narrower than the pads 515. Though, in other instances, the bumps 525 and the pads 515 may have substantially similar widths, or the bump 525 may be wider than the pads 515. The bridge 520 may be in direct contact with the buildup layers 514. Other embodiments may include a dielectric layer (not shown) between the bridge 520 and the buildup layers 514.

Referring now to Figure 5B, a zoomed in cross-sectional illustration of an interconnect between the bridge 520 and the buildup layers 514 is shown, in accordance with an additional embodiment. As shown, a dielectric layer 509 separates the bridge 520 from the buildup layers 514. The dielectric layer 509 may be an underfill material, a non-conductive film, a non-conductive paste, or the like. In an embodiment, the bump 525 and pad 515 may be provided within the dielectric layer 509.

In an embodiment, the bump 525 and the pad 515 may comprise the same or similar material as the remainder of the electrical routing (not shown in Figure 5B) in the buildup layers 514. However, a liner 508 may be provided on the bump 525 and a liner 507 may be provided on the pad 515. The liners 508 and 507 may comprise high electrical conductivity material or materials, such as, but not limited to, gold or silver.

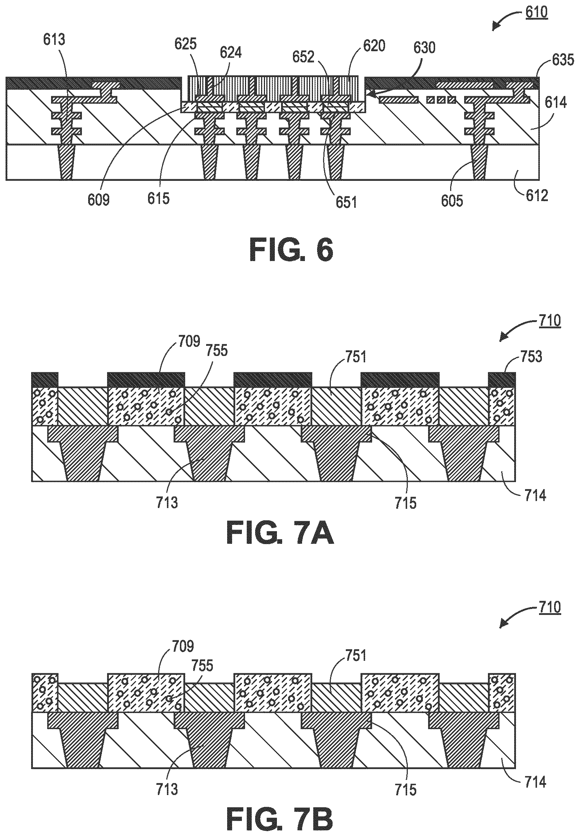

Referring now to Figure 6, a cross-sectional illustration of a package substrate 610 is shown, in accordance with an embodiment. The package substrate 610 may comprise a core 612 with buildup layers 614 over and under (not shown) the core 612. The core 612 may be a glass core or an organic core. The core 612 may be similar to any core described in greater detail herein. In an embodiment, vias 605 pass through a thickness of the core 612. Electrical routing (e.g., vias 613, pads 615, traces, and the like) may be embedded in the buildup layers 614. A solder resist 635 may be provided over the buildup layers 614.

In an embodiment, a bridge 620 is inserted into a cavity 630 into the buildup layers 614. The bridge 620 may be similar to any bridge architecture described in greater detail herein. In an embodiment, the bridge 620 comprises vias 624 (e.g., TSVs) with pads 625 at a bottom of the bridge 620. In an embodiment, the pads 625 may be bonded to pads 615 by an interconnect that includes a first bump 651 and a second bump 652. The bumps 651 and 652 may comprise copper or the like. The bumps 651 and 652 may be surrounded by a dielectric layer 609. Between the dielectric layer 609 and the bumps 651 and 652, the interconnect architecture between the bridge 620 and the buildup layer 614 may be considered a hybrid bonding architecture.

Referring now to Figures 7A - 7C, a series of cross-sectional illustrations depicting a process for hybrid bonding a bridge 720 to buildup layers 714 is shown, in accordance with an embodiment.

Referring now to Figure 7A, a cross-sectional illustration of a package substrate 710 with buildup layers 714 is shown, in accordance with an embodiment. The portion of the package substrate 710 shown in Figure 7A is within a cavity into the buildup layers 714. The sidewalls of the cavity are omitted for simplicity. A via 713 may connect to a pad 715. In an embodiment, first bumps 751 are provided over the pads 715. A dielectric layer 709 is provided around the first bumps 751. The dielectric layer 709 may comprise filler particles 755.

The filler particles 755 allow for improved compression of the dielectric layer 709 during bonding operations. For example, the filler particles 755 may be hollow spheres (e.g., air filled spheres) that are deformable or prone to fracture when exposed to compressive forces. The shell of the spheres may comprise silica or the like. The filler particles 755 may occupy up to approximately 50% of an area of the dielectric layer 709. A patterning layer 753 may be provided over the dielectric layer 709.

Referring now to Figure 7B, a cross-sectional illustration of the package substrate 710 after a planarization process is shown, in accordance with an embodiment. As shown, the planarization process (e.g., chemical mechanical polishing (CMP)) may result in the removal of the patterning layer 753 and recess the top surface of the first bumps 751. That is, a height of the first bumps 751 may be less than a height of the dielectric layer 709. Accordingly, without the ability to compress the dielectric layer 709, proper bonding in a subsequent operation cannot be accomplished.

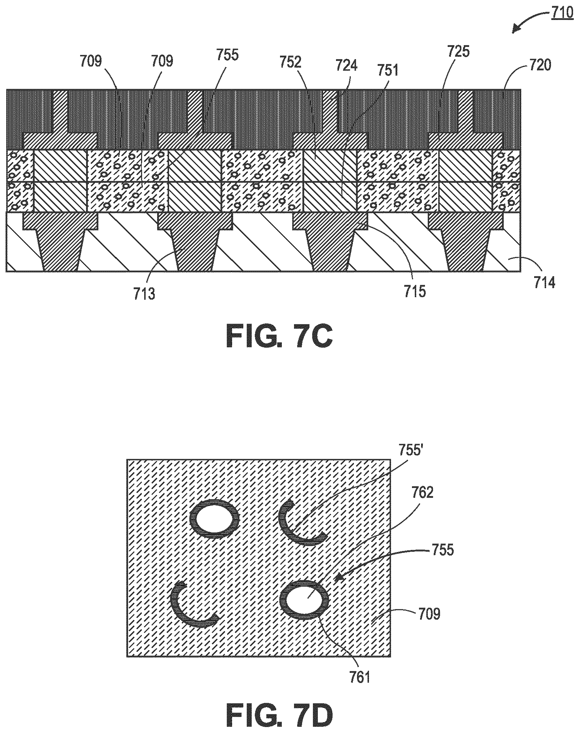

Referring now to Figure 7C, a cross-sectional illustration of the package substrate 710 after the bridge 720 is attached is shown, in accordance with an embodiment. The bridge 720 may comprise vias 724 (e.g., TSVs) and pads 725. Second bumps 752 may be provided over the pads 725, and the second bumps 752 are surrounded by a dielectric layer 709 similar to the one around the first bumps 751. That is, the dielectric layer 709 may also include filler particles 755.

During the bonding process (e.g., a thermocompression bonding (TCB) process), the dielectric layers 709 may be compressed to allow first bumps 751 to directly contact second bumps 752. The compression may be enabled through the deformation of the filler particles 755. For example, the filler particles 755 may be deformed, cracked, or otherwise damaged.

Referring now to Figure 7D, a zoomed in illustration of the dielectric layer 709 is shown, in accordance with an embodiment. As shown, the filler particles 755 may include an outer shell 761 and an inner void 762 (e.g., an air filled void 762). The illustration in Figure 7D shows compressed filler particles 755. For example, the cross-sectional shape of the filler particles 755 may be elliptical or the like. In some instances, the filler particles 755 may be referred to as having a spheroidal shell structure. Additionally, some of the filler particles 755' may be cracked or otherwise damaged. In such instances, the outer shell is not a completely enclosed structure, and the dielectric material may at least partially fill locations that previously included voids 762.

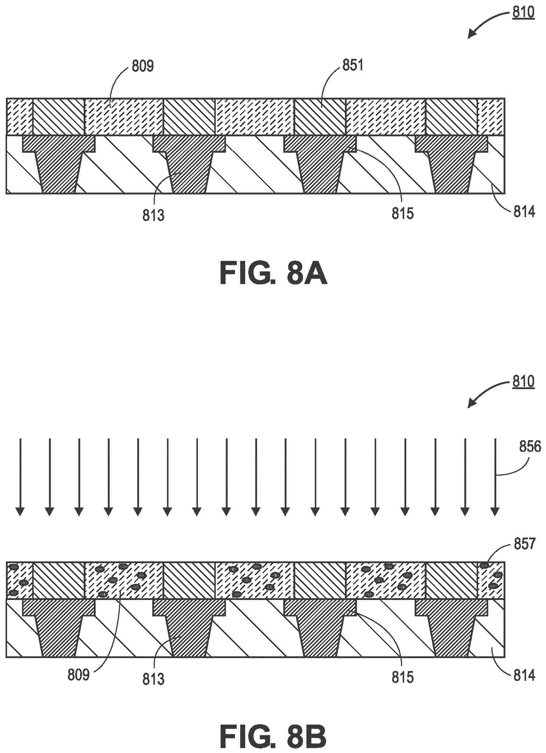

Referring now to Figures 8A - 8C, a series of cross-sectional illustrations depicting a process for hybrid bonding a bridge 820 to buildup layers 814 is shown, in accordance with an embodiment.

Referring now to Figure 8A, a cross-sectional illustration of a package substrate 810 with buildup layers 814 is shown, in accordance with an embodiment. The portion of the package substrate 810 shown in Figure 8A is within a cavity into the buildup layers 814. The sidewalls of the cavity are omitted for simplicity. A via 813 may connect to a pad 815. In an embodiment, first bumps 851 are provided over the pads 815. A dielectric layer 809 is provided around the first bumps 851.

Referring now to Figure 8B, a cross-sectional illustration of the package substrate 810 after a vapor infiltration process 856 is shown, in accordance with an embodiment. The vapor infiltration process 856 allows for filler particles 857 to be integrated into the dielectric layer 809. Since the vapor infiltration process 856 is applied into the top surface of the dielectric layer 809, the distribution of filler particles 857 may be non-uniform through a thickness of the dielectric layer 809. For example, a top region of the dielectric layer 809 may have a higher density of filler particles 857 than a lower region of the dielectric layer 809. In general, the area of the dielectric layer 809 occupied by filler particles 857 may be up to approximately 50% in some embodiments.

The filler particles 857 may be inorganic fillers that are generated from metalorganic precursor materials in the vapor infiltration process 856. The inclusion of filler particles 857 may provide several benefits. For one, the mechanical robustness of the dielectric layer 809 is increased. Additionally, the filler particles 857 may be used to modulate the CTE of the dielectric layer 809 to more closely match that of the first bumps 851.

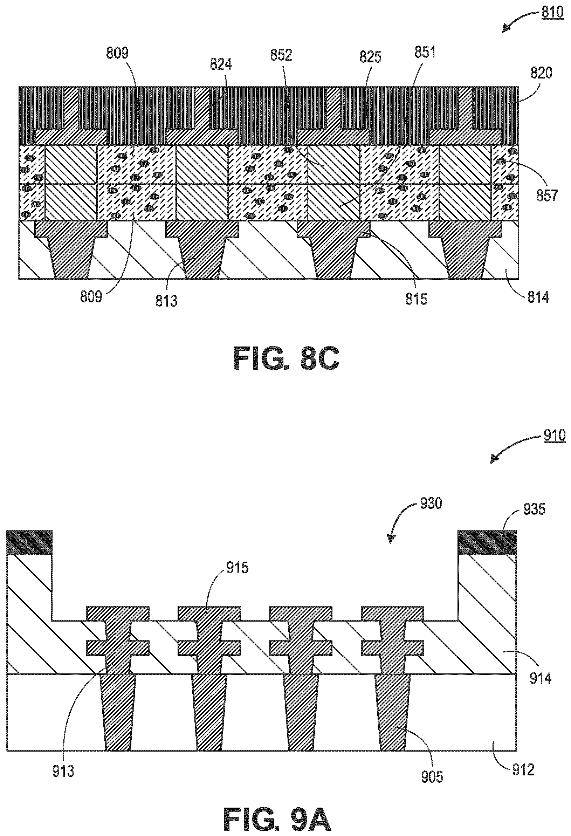

Referring now to Figure 8C, a cross-sectional illustration of the package substrate 810 after the bridge 820 is attached is shown, in accordance with an embodiment. The bridge 820 may comprise vias 824 (e.g., TSVs) and pads 825. Second bumps 852 may be provided over the pads 825, and the second bumps 852 are surrounded by a dielectric layer 809 similar to the one around the first bumps 851. That is, the dielectric layer 809 may also include filler particles 857.

During the bonding process (e.g., a TCB process), the opposing dielectric layers 809 may be bonded together. Similarly, the first bumps 851 may be bonded to the second bumps 852. As such, a dielectric-to-dielectric bond and a metal-to-metal bond is provided to generate a hybrid bonding interface.

Referring now to Figures 9A - 9E, a series of cross-sectional illustrations depicting a process for assembling a package substrate 910 with a bridge 920 that is bonded to a bottom surface of a cavity 930 in buildup layer 914 is shown, in accordance with an embodiment.

Referring now to Figure 9A, a cross-sectional illustration of a package substrate 910 with buildup layers 914 is shown, in accordance with an embodiment. The portion of the package substrate 910 shown in Figure 9A is centered on a cavity 930 into the buildup layers 914. A via 913 may connect to a pad 915. In an embodiment, the buildup layers 914 may be provided over a core 912, such as a glass core or an organic core. The core 912 may have vias 905. A solder resist 935 may be provided over the buildup layers 914.

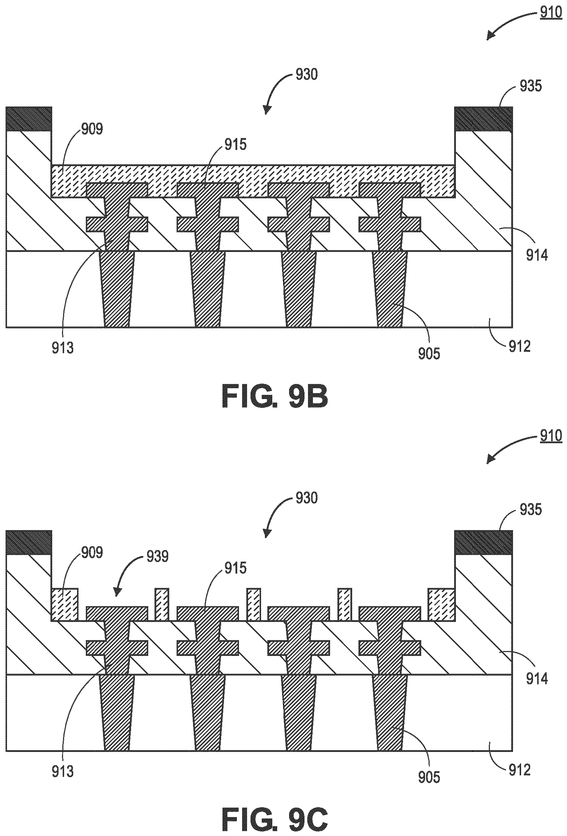

Referring now to Figure 9B, a cross-sectional illustration of the package substrate 910 after a dielectric layer 909 is added into the bottom of the cavity 930 around pads 915 is shown, in accordance with an embodiment. The dielectric layer 909 may be deposited with a spray coating process or the like. In an embodiment, the dielectric layer 909 may be a B-stage dielectric material, such as a B-stage epoxy. That is, the dielectric layer 909 may have two or more curing stages. After the first cure, the dielectric layer 909 may remain compliant and allow for continued deformation to improve interconnect bonding performance. After deposition, the dielectric layer 909 may be cured to the first cure stage.

Referring now to Figure 9C, a cross-sectional illustration of the package substrate 910 after the dielectric layer 909 is patterned to form openings 939 over the pads 915 is shown, in accordance with an embodiment. In an embodiment, the openings 939 may be wider than the width of the pads 915. The openings 939 may be formed with any patterning process, such as lithography, laser ablation, or the like.

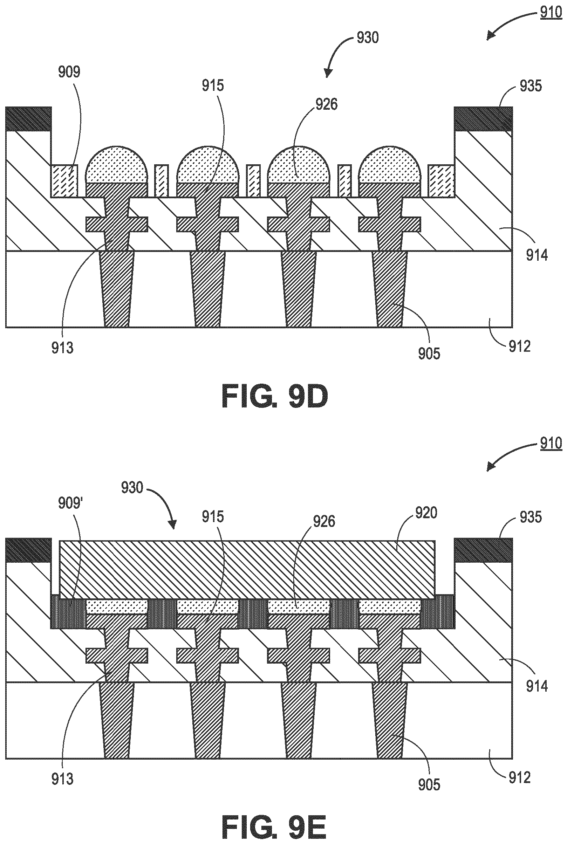

Referring now to Figure 9D, a cross-sectional illustration of the package substrate 910 after solder 926 is applied on the pads 915 is shown, in accordance with an embodiment. In an embodiment, the solder 926 may be any standard solder material, such as a tin-based solder or the like.

Referring now to Figure 9E, a cross-sectional illustration of the package substrate 910 after the bridge 920 is attached is shown, in accordance with an embodiment. The bridge 920 may be similar to any of the bridge structures described in greater detail herein. For example, the bridge 920 may comprise TSVs or the like. The bridge 920 may be bonded with a TCB process. The TCB process may reflow the solder 926. Additionally, during the TCB bonding process, the dielectric layer 909' may be cured again so that it forms a B-stage material. The dielectric layer 909' may also deform during bonding in order to contact the solder 926 and form a strong bond between the bridge 920 and the buildup layers 914. As such, reliability and performance of the package substrate 910 is improved.

It is to be appreciated that the three embodiments in Figures 7A - 9E can be used individually, two of the three embodiments can be used together, or all three embodiments can be used together. That is, any combination may be used in order to provide the desired reliability and performance in a package substrate that includes a bridge with TSVs that is electrically coupled to the buildup layers at the bottom of a cavity.

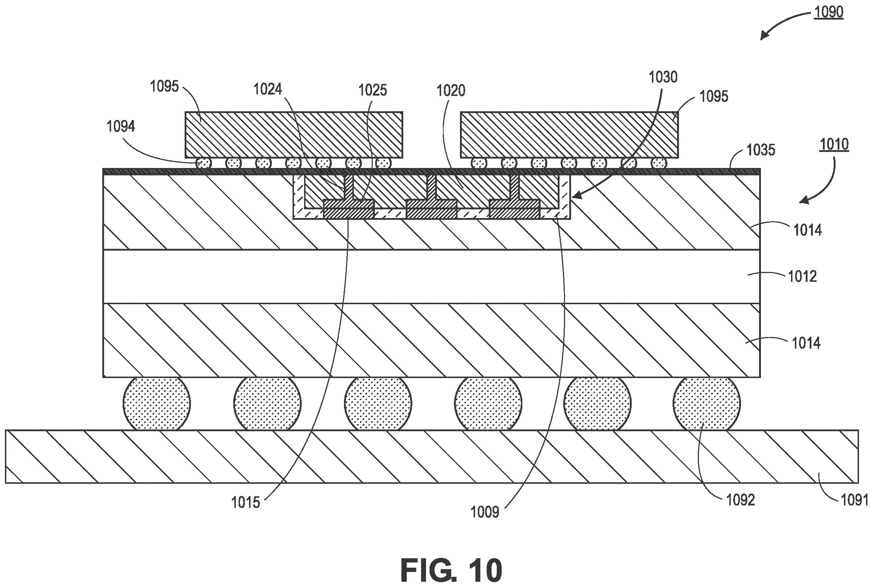

Referring now to Figure 10, a cross-sectional illustration of an electronic system 1090 is shown, in accordance with an embodiment. The electronic system 1090 may comprise a board 1091, such as a printed circuit board (PCB), a motherboard, or the like. The board 1091 may be coupled to a package substrate 1010 through second level interconnects (SLIs) 1092. The SLIs 1092 may comprise solder joints, pins, sockets, or the like.

In an embodiment, the package substrate 1010 may be similar to any of the package substrates described in greater detail herein. For example, the package substrate 1010 may comprise a core 1012 with buildup layers 1014 above and below the core 1012. The core 1012 may be similar to any of the cores described in greater detail herein. In an embodiment, a bridge 1020 is embedded in a cavity 1030 into the buildup layers 1014. The bridge 1020 may include vias 1024 (e.g., TSVs) that end at pads 1025. The pads 1025 may be directly bonded to pads 1015 on the bottom surface of the cavity 1030. A dielectric layer 1009 or underfill may surround the interconnects below the bridge 1020. The interconnect between the bridge 1020 and the buildup layers 1014 may be referred to as a hybrid bonding interconnect in some embodiments. Though, solder (e.g., a single solder, or a solder and a porous bump) may also be used as the interconnect in other embodiments. A solder resist 1035 may be provided at the top of the package substrate 1010.

In an embodiment, a pair of dies 1095 may be communicatively coupled together through the bridge 1020. For example, first level interconnects (FLIs) 1094 may couple the dies 1095 to the package substrate 1010 and the bridge 1020. The dies 1095 may comprise a central processing unit (CPU), a graphics processing unit (GPU), an XPU, a communications die, a memory die, an application-specific integrated circuit (ASIC), a field programmable gate array (FPGA), or the like.

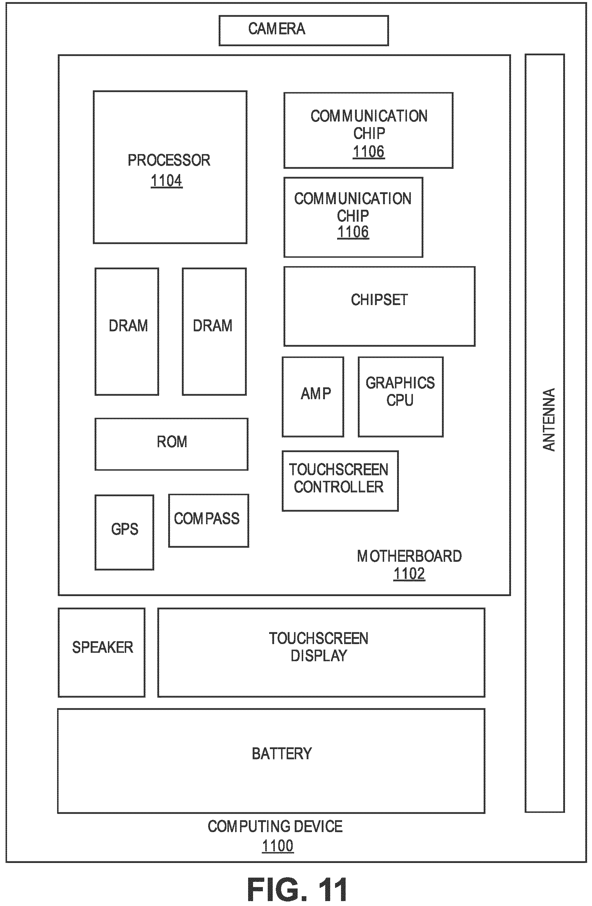

Figure 11 illustrates a computing device 1100 in accordance with one implementation of the disclosure. The computing device 1100 houses a board 1102. The board 1102 may include a number of components, including but not limited to a processor 1104 and at least one communication chip 1106. The processor 1104 is physically and electrically coupled to the board 1102. In some implementations the at least one communication chip 1106 is also physically and electrically coupled to the board 1102. In further implementations, the communication chip 1106 is part of the processor 1104.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1106 enables wireless communications for the transfer of data to and from the computing device 1100. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1106 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1100 may include a plurality of communication chips 1106. For instance, a first communication chip 1106 may be dedicated to shorter range wireless communications such as Wi-Fi and Bluetooth and a second communication chip 1106 may be dedicated to longer range wireless communications such as GPS, EDGE, GPRS, CDMA, WiMAX, LTE, Ev-DO, and others.

The processor 1104 of the computing device 1100 includes an integrated circuit die packaged within the processor 1104. In some implementations of the disclosure, the integrated circuit die of the processor may be part of an electronic package that includes a bridge that is bonded to the package substrate through a hybrid bonding interface, in accordance with embodiments described herein. The term "processor" may refer to any device or portion of a device that processes electronic data from registers and/or memory to transform that electronic data into other electronic data that may be stored in registers and/or memory.

The communication chip 1106 also includes an integrated circuit die packaged within the communication chip 1106. In accordance with another implementation of the disclosure, the integrated circuit die of the communication chip may be part of an electronic package that includes a bridge that is bonded to the package substrate through a hybrid bonding interface, in accordance with embodiments described herein.

In an embodiment, the computing device 1100 may be part of any apparatus. For example, the computing device may be part of a personal computer, a server, a mobile device, a tablet, an automobile, or the like. That is, the computing device 1100 is not limited to being used for any particular type of system, and the computing device 1100 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: an apparatus, comprising: a substrate, wherein the substrate comprises a dielectric material; a cavity into a surface of the substrate; a first pad on a bottom surface of the cavity; a die at least partially in the cavity; a via that passes through at least a portion of a thickness of the die; and a second pad on the die, wherein the second pad directly contacts the first pad, and wherein the first pad is the only electrically conductive structure between the via and the second pad.

Example 2: the apparatus of Example 1, wherein a surface of the die directly contacts the bottom surface of the cavity.

Example 3: the apparatus of Example 1 or Example 2, wherein one or both of the first pad and the second pad comprise gold or silver.

Example 4: the apparatus of Examples 1-3, further comprising: a layer between the die and the bottom surface of the cavity.

Example 5: the apparatus of Example 4, wherein a spheroidal shell is embedded in the layer.

Example 6: the apparatus of Example 5, wherein the spheroidal shell is cracked.

Example 7: the apparatus of Examples 4-6, further comprising inorganic fillers embedded in the layer.

Example 8: the apparatus of Examples 4-7, wherein the layer is a B-stage material.

Example 9: the apparatus of Examples 1-8, wherein the substrate is over a core.

Example 10: the apparatus of claim 9, wherein the core comprises a solid glass layer with a rectangular prism volume.

Example 11: an apparatus, comprising: a substrate; a cavity into a surface of the substrate; a first pad on a bottom surface of the cavity; a die at least partially within the cavity; a second pad on the die; and an interconnect between the first pad and the second pad, wherein the interconnect comprises a first portion with a first material composition and a second portion with a second material composition.

Example 12: the apparatus of Example 11, wherein the first portion comprises a porous metal.

Example 13: the apparatus of Example 12, wherein the porous metal comprises one or more of tin, copper, or nickel.

Example 14: the apparatus of Example 12 or Example 13, wherein up to approximately 50% of a cross-sectional area of the porous metal comprises air.

Example 15: the apparatus of Examples 11-14, wherein an interface between the first portion and the second portion is curved.

Example 16: the apparatus of Examples 11-15, wherein the first portion comprises a lateral protrusion.

Example 17: an apparatus, comprising: a board; a package substrate over the board, wherein the package substrate comprises: a core; buildup layers over the core; and a bridge with a via embedded in the buildup layers, wherein the bridge is bonded to the buildup layers with a hybrid bonding architecture; a first die over the package substrate; and a second die over the package substrate, wherein the first die is communicatively coupled to the second die by the bridge.

Example 18: the apparatus of Example 17, wherein the core comprises glass with a rectangular prism shape.

Example 19: the apparatus of Example 17 or Example 18, wherein the hybrid bonding architecture comprises a copper-to-copper bond and a dielectric-to-dielectric bond.

Example 20: the apparatus of Examples 17-19, wherein the apparatus is part of a personal computer, a server, a mobile device, a tablet, or an automobile.

## Claims

1. An apparatus, comprising:
a substrate, wherein the substrate comprises a dielectric material;
a cavity into a surface of the substrate;
a first pad on a bottom surface of the cavity;
a die at least partially in the cavity;
a via that passes through at least a portion of a thickness of the die; and
a second pad on the die, wherein the second pad directly contacts the first pad, and wherein the first pad is the only electrically conductive structure between the via and the second pad.

2. The apparatus of claim 1, wherein a surface of the die directly contacts the bottom surface of the cavity.

3. The apparatus of claim 1 or 2, wherein one or both of the first pad and the second pad comprise gold or silver.

4. The apparatus of claim 1, 2 or 3, further comprising:
a layer between the die and the bottom surface of the cavity.

5. The apparatus of claim 4, wherein a spheroidal shell is embedded in the layer.

6. The apparatus of clam 5, wherein the spheroidal shell is cracked.

7. The apparatus of claim 4, 5 or 6, further comprising inorganic fillers embedded in the layer.

8. The apparatus of claim 4, 5, 6 or 7, wherein the layer is a B-stage material.

9. The apparatus of claim 1, 2, 3, 4, 5, 6, 7 or 8, wherein the substrate is over a core.

10. The apparatus of claim 9, wherein the core comprises a solid glass layer with a rectangular prism volume.

11. A method of fabricating an apparatus, the method comprising:
providing a substrate, wherein the substrate comprises a dielectric material;
forming a cavity into a surface of the substrate;
forming a first pad on a bottom surface of the cavity;
providing a die at least partially in the cavity;
providing a via that passes through at least a portion of a thickness of the die; and
providing a second pad on the die, wherein the second pad directly contacts the first pad, and wherein the first pad is the only electrically conductive structure between the via and the second pad.

12. The method of claim 11, wherein a surface of the die directly contacts the bottom surface of the cavity.

13. The method of claim 11 or 12, wherein one or both of the first pad and the second pad comprise gold or silver.

14. The method of claim 11, 12 or 13, further comprising:
forming a layer between the die and the bottom surface of the cavity.

15. The method of claim 14, wherein a spheroidal shell is embedded in the layer.
